# EUROPEAN PATENT APPLICATION

(11) **EP 1 596 436 A1**
(43) Date of publication of application: **16.11.2005**
(21) Application number: 04076399.7
(22) Date of filing: 12.05.2004
(51) Int. Cl.: H01L 25/07

(54) **Electronic circuit and method for manufacturing an electronic circuit**

(71) Applicant: SEIKO EPSON CORPORATION, Tokyo 160-0811 (JP)
(72) Inventor: Kazuaki, Tanaka, Epson Europe Electronics GMBH, 08190 Sant Cugat del Vallès, Barcelona (ES)
(74) Representative: Davila Baz, Angel

(57) **Abstract**

The invention relates to an electronic circuit comprising a first terminal (100) and a second terminal (200, 300) and at least three transistors (1) arranged in parallel, each transistor having a control terminal (2) connected to said first terminal (100) for receiving a control signal, and an output terminal (3, 4) connected to said second terminal (200, 300) for providing an output signal, said output signal depending on the control signal.

The transistors (1) are arranged symmetrically with regard to a point of symmetry, in a manner such that the contribution to the heating of a transistor by heat received from the other transistors, is substantially the same for all of said transistors.

The invention also relates to a method for manufacturing an electronic circuit.

## Description

### TECHNICAL FIELD

The invention relates to transistor circuits, especially to power amplifier circuits including power transistors.

### STATE OF THE ART

Frequently, individual transistors are coupled in parallel in order to obtain an output signal corresponding to the sum of the individual output signals of the transistors. For example, in power amplifier circuits, a plurality of power transistors are often connected in parallel in order to provide for high output power. That is, for example, in a power amplifier circuit, a plurality of transistors can be connected in parallel, each transistor having a control terminal (for example, in the case of bipolar transistors, the base) connected to a first terminal (control terminal) of the circuit, for receiving a control signal, and an output terminal (for example, in the case of bipolar transistors, the collector and/or the emitter) connected to a second terminal of the circuit, for providing a composite output signal at said second terminal; the output signal depends on the control signal and is the sum of the output signal at the output terminals of the individual transistors.

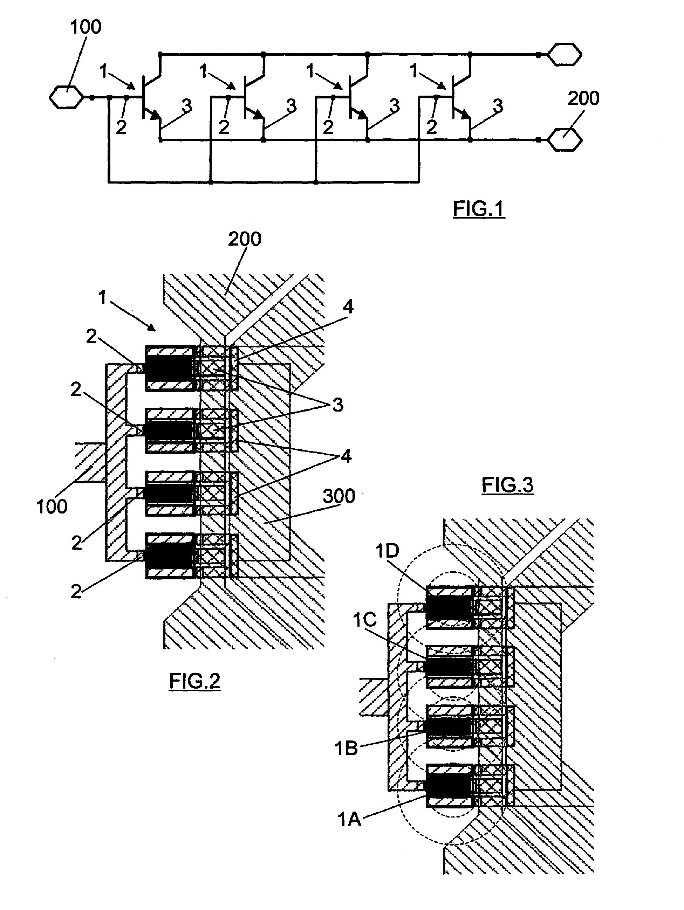

Normally, in this kind of circuits, the transistors are placed in an array, as shown in **Figures 1-3. Figure 1** is a circuit diagram illustrating schematically how a plurality of transistors 1 are coupled in parallel; each transistor has a control terminal 2 (in the case of a bipolar transistor, its base) connected to a first terminal 100 of the circuit, and an output terminal 3 (in **figure 1**, the emitter of the illustrated bipolar transistors) connected to a second terminal 200 of the circuit. Thus, the output signal at said second terminal 200 corresponds to the sum of the output signals at the output terminals 3 of the individual transistors, and this output signal can be controlled by a control signal applied to the first terminal 100 of the circuit.

**Figure 2** shows a conventional layout of a circuit as described above, using bipolar power transistors. The control terminals (bases) 2 of the transistors are connected to a first terminal 100 of the circuit, at which the control signal is applied. The output terminals (emitters) 3 are connected to the second terminal 200 of the circuit, whereas the collectors 4 (which can also be regarded as output terminals) are connected to a further second terminal 300 of the circuit. Normally, the transistors are arranged in an array, that is, in one single row, as schematically illustrated in **figure 2.**

By applying a control signal to the control terminals 2 of the transistors 1, a high power output can be obtained at the second terminal 200. However, during operation, heat is generated in the individual power transistors 1. As a consequence, during operation, the temperature of each transistor rises, due to the heat generated by the transistor itself and, also, due to heat received from the surrounding or adjacent transistors of the circuit.

When the transistors are arranged in the conventional linear arrangement, that is, in one single row, the transistors are heated differently depending on whether they are at the end of the row or not, as schematically illustrated in **figure 3,** illustrating the arrangement of **figure 2,** comprising four transistors here referred to as 1A, 1B, 1C and 1D, arranged in a row. The circles schematically illustrate the irradiation of heat from each transistor. Basically, the transistors irradiate heat in all directions. Obviously, as is easily understood from **figure 3,** if the heat generated in each transistor is the same, the temperature of the transistors 1B and 1C (inside the row) will be higher than the temperature of the transistors 1A and 1D (at the end of the row), as the transistors 1B and 1C are substantially heated by two neighbouring transistors. That is, for example, transistor 1B is heated by the heat produced by the transistor 1B itself and, also, to a substantial extent, by heat coming from transistors 1A and 1C (however, transistor 1D is not contributing to a substantial extent to the heating of transistor 1B, as it is rather far away from the transistor 1B). However, transistor 1A, placed at the end of the row, is only heated by the heat produced by transistor 1A itself and by the heat coming from transistor 1B; the transistors 1C and 1D are far away and do not contribute substantially to the heating of transistor 1A.

That is, there will be a non-uniform temperature distribution: different transistors of the circuit will have different temperatures, namely, during operation, the transistors inside the row -1B, 1C- will probably have a higher temperature than the transistors at the end of the row -1A, 1D-; the different temperatures of the transistors will give rise to differences in carrier mobility between the transistors. This is disadvantageous, as it will affect the characteristics of the circuit (for example, signal phase, power gain or power added efficiency -PAE-of a power amplifier) and its reliability.

Often, miniaturisation of the circuits is desired; for example, there is a need for miniaturised power amplifier circuits for mobile telephony. However, miniaturisation of the circuits tend to imply stricter requirements on temperature related issues, as components tend to get closer to each other, and as there is less space for incorporating heat absorbing structures (heat sinks).

JP-A-06-349837 discloses a semiconductor device in which, in order to improve the temperature distribution inside the device caused by heat generated in the device, when at least three semiconductor elements are arranged in a comb-shape, a lead-out part which is thicker than other lead-out parts is arranged at each odd-numbered semiconductor element. Thereby, it is possible to arrange a bonding pad just near said thicker lead-out part, which makes it possible to reduce the irregularities in the temperature and to improve the temperature distribution inside the device. That is, basically, a bonding pad is inserted between every even number of transistors. However, this requires large area bonding pads and a large area of the circuit, which does not seem desirable when it comes to miniaturisation of circuits.

JP-A-6-310545 discloses a semiconductor device having a layout aiming at lowering the maximum temperature of the device and unifying the temperature of the respective amplifying parts. This seems to be done by making the gap between elements large at the centre of the row, and decreasing it towards the ends of the row. However, this seems to require careful control of the distances all along the row, and a risk for mismatch between the characteristics at both ends of the row.

JP-A-2003-347851 shows an arrangement using a circuit for temperature compensation; however, this requires an increase of the chip size.

Thus, it has been considered desirable to provide for an alternative manner of obtaining an adequate temperature distribution over the circuit and for avoiding an excessive heating of certain parts of the circuit, without any need for additional elements; the solution should preferably be suitable for miniaturisation of the circuits.

### DESCRIPTION OF THE INVENTION

One aspect of the invention relates to an electronic circuit comprising a first terminal, a second terminal and at least three transistors arranged in parallel, each transistor having a control terminal connected to said first terminal for receiving a control signal, and an output terminal connected to said second terminal for providing an output signal, said output signal depending on the control signal. Thus, by applying a control signal to the first terminal of the circuit (and, thus, to the control terminals of the transistors), a controlled composite output signal can be obtained at the second terminal, said signal corresponding to the sum of the output signals of the individual transistors.

In accordance with the invention, said transistors are arranged symmetrically with regard to a point of symmetry, in a manner such that the contribution to the heating of a transistor by heat received from the other transistors, is substantially the same for all of said transistors. In this manner, and contrarily to what happened in the "linear" layout described above (in which the transistors are arranged in one single row), no transistor will be heated more than other transistors due to heat received from adjacent transistors; if the self-heating (the heating that takes place due to currents flowing through the transistors) is the same for all transistors, the total heating of the transistors will also be substantially the same, thus providing for uniform temperature distribution and characteristics of the transistors.

Preferably, each transistor is placed at the same distance from the point of symmetry.

Preferably, the transistors are placed in a regular pattern around the point of symmetry, the distance between a transistor and the closest two adjacent transistors being substantially the same for all transistors.

The transistors can all be placed in the same plane.

The transistors can be bipolar transistors, in which case the control terminal will be the base and the output terminal the emitter and/or the collector of the transistors.

However, the transistors can also be any other kind of transistors, for example, field effect transistors (FETs).

The invention is considered to be especially advantageous if the transistors are power transistors. The circuit can be a power amplifier.

Another aspect of the invention relates to a composite transistor circuit, comprising a plurality of circuits as described above, said circuits being arranged in a regular matrix pattern having a plurality of rows and columns, each row and column comprising a plurality of circuits, the distance between two adjacent circuits in a row being substantially the same as the distance between two adjacent circuits in a column. Thereby, a large "composite" circuit can be obtained, comprising a large number of transistors distributed in small circuits with a relatively homogeneous temperature distribution.

Another aspect of the invention relates to a method for manufacturing an electronic circuit, comprising the step of arranging a plurality of transistors on a substrate such that each transistor has a control terminal connected to a first terminal of the circuit for receiving a control signal, and an output terminal connected to a second terminal of the circuit for providing an output signal, said output signal depending on the control signal.

According to the invention, the transistors are arranged symmetrically with regard to a point of symmetry, in a manner so that the contribution to the heating of a transistor by heat received from the other transistors, is substantially the same for all of said transistors. In this manner, the invention achieves the objectives outlined above.

Each transistor can be placed at the same distance from the point of symmetry.

The transistors can be placed in a regular pattern around the point of symmetry, the distance between each transistor and the closest two adjacent transistors being the same for all transistors.

A further aspect of the invention relates to a method for manufacturing a composite electric circuit, comprising the step of producing a plurality of electric circuits, whereby each circuit is produced following the method described above. According to this aspect of the invention, the electric circuits are distributed regularly over a surface, in a matrix pattern having a plurality of rows and columns, each row and column comprising a plurality of circuits, the distance between two adjacent circuits in a row being substantially the same as the distance between two adjacent circuits in a column.

### BRIEF DESCRIPTION OF THE DRAWINGS

Figures 1-3 schematically illustrate an electronic circuit according to a prior art arrangement of the transistors.
Figures 4-5 schematically illustrate an electronic circuit according to a preferred embodiment of the invention.
Figure 6 schematically illustrates a composite circuit comprising a plurality of circuits in accordance with the invention.

### DESCRIPTION OF A PREFERRED EMBODIMENT OF THE INVENTION

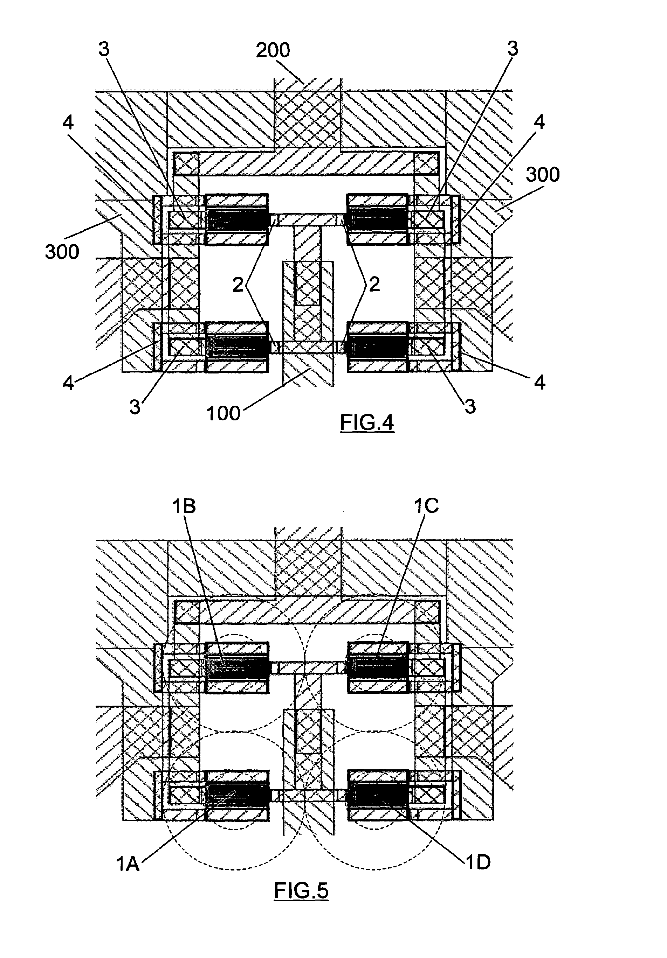

**Figure 4** illustrates a circuit in which four bipolar transistors are arranged in parallel, forming a circuit according to the circuit diagram of **figure 1** but, instead of being arranged in a row as in **figures 2** and **3,** in **figure 4** the four transistors are distributed regularly, in accordance with the angles of a square; the control terminals (bases) 2 are connected to the first terminal 100 of the circuit at the centre of the square, whereas output terminals (in this embodiment, the emitters) 3 are connected to the second terminal 200 at the periphery of the square. Also, the figure shows how further output terminals, namely, the collectors 4 are connected to a further second terminal 300 of the circuit.

Using this arrangement or layout, the distance from each transistor to a point of symmetry (the centre of the square) is the same, and also the distance between a transistor and the adjacent transistors is the same, for all of the transistors. Thus, it is achieved that no transistor is heated more than any other transistor due to heat coming from the other transistors of the circuit, thereby providing a more regular temperature distribution in the circuit, and reducing the discrepancy in carrier mobility between the different transistors. **Figure 5** schematically illustrates the irradiation of heat from the transistors 1A, 1B, 1C, 1D; none of said transistors receives more heat from the adjacent transistors than the other ones.

In the preferred embodiment described herein, bipolar transistors have been used, but the invention is equally aplicable to other kinds of transistors, for example, FETs, etc. Also, the circuit can comprise any number of transistors, for example, eight transistors forming an octagon pattern, etc.

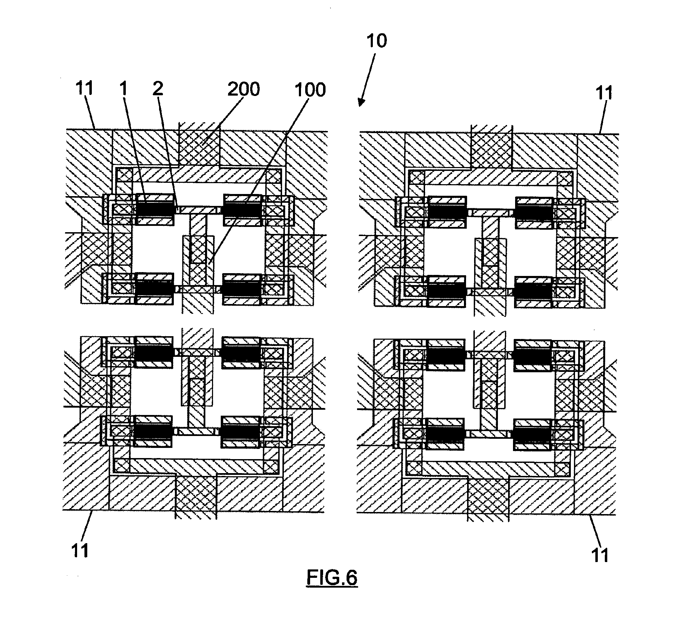

**Figure 6** schematically illustrates a composite circuit 10, comprising a plurality of circuits 11 as described above, each one of them comprising a plurality of transistors 1 arranged as outlined above. In this way, very large arrangements of transistors connected in parallel can be obtained, with a good temperature distribution over most of the circuit without any need for complex structures for reducing differences in heat distribution.

Throughout the description and claims of the specification, the word "comprise" and variations of the word, such as "comprising", is not intended to exclude other additives, components, integers or steps.

## Claims

1. An electronic circuit comprising a first terminal (100) and a second terminal (200) and at least three transistors (1) arranged in parallel, each transistor having a control terminal (2) connected to said first terminal (100) for receiving a control signal, and an output terminal (3, 4) connected to said second terminal (200, 300) for providing an output signal, said output signal depending on the control signal,
**characterised in that**
said transistors (1) are arranged symmetrically with regard to a point of symmetry, in a manner such that the contribution to the heating of a transistor by heat received from the other transistors, is substantially the same for all of said transistors.

2. An electronic circuit according to claim 1, wherein each transistor is placed at a distance from the point of symmetry, said distance being the same for all transistors.

3. An electronic circuit according to any of the preceding claims, wherein the transistors are placed in a regular pattern around the point of symmetry, the distance between a transistor and the closest two adjacent transistors being the same for all transistors.

4. An electronic circuit according to any of the preceding claims, wherein the transistors are situated in the same plane.

5. An electronic circuit according to any of the preceding claims, wherein the transistors are bipolar transistor, the control terminal (2) being the base and the output terminal being the emitter (3) and/or the collector (4) of the transistors.

6. An electronic circuit according to any of claims 1-4, wherein the transistors are field effect transistors.

7. An electronic circuit according to any of the preceding claims, wherein the transistors are power transistors.

8. An electronic circuit according to any of the preceding claims, wherein said circuit is a power amplifier.

9. A composite transistor circuit, comprising a plurality of circuits according to any of the preceding claims, arranged in a regular matrix pattern having a plurality of rows and columns, each row and column comprising a plurality of circuits, the distance between two adjacent circuits in a row being substantially the same as the distance between two adjacent circuits in a column.

10. A method for manufacturing an electronic circuit, comprising the steps of:
arranging at least three transistors on a substrate such that each transistor has a control terminal (2) connected to a first terminal (100) of the circuit for receiving a control signal, and an output terminal (3, 4) connected to a second terminal (200, 300) of the circuit for providing an output signal at said second terminal, said output signal depending on the control signal,
**characterised in that**
said transistors (1) are arranged symmetrically with regard to a point of symmetry, in a manner such that the contribution to the heating of a transistor by heat received from the other transistors, is substantially the same for all of said transistors.

11. A method according to claim 10, wherein each transistor is placed at a distance from the point of symmetry, said distance being the same for all transistors.

12. A method according to claim 11, wherein the transistors are placed in a regular pattern around the point of symmetry, the distance between each transistor and the closest two adjacent transistors being the same for all transistors.

13. A method for manufacturing a composite electric circuit, comprising the step of producing a plurality of electric circuits, whereby each circuit is produced following the method of any of claims 10-12, whereby the electric circuits are distributed regularly over a surface, in a matrix pattern having a plurality of rows and columns, each row and column comprising a plurality of circuits, the distance between two adjacent circuits in a row being substantially the same as the distance between two adjacent circuits in a column.
